Europäisches Patentamt

European Patent Office

Office européen des brevets

(11) Veröffentlichungsnummer: **0 268 136**
**A2**

(12) **EUROPÄISCHE PATENTANMELDUNG**

(21) Anmeldenummer: **87116138.6**

(22) Anmeldetag: **03.11.87**

(51) Int. Cl.⁴: **H01L 29/72**

(30) Priorität: **18.11.86 DE 3639433**

(43) Veröffentlichungstag der Anmeldung:
**25.05.88 Patentblatt 88/21**

(84) Benannte Vertragsstaaten:
**DE FR GB IT**

(71) Anmelder: **TELEFUNKEN electronic GmbH**
**Theresienstrasse 2**
**D-7100 Heilbronn(DE)**

(72) Erfinder: **Beneking, Heinz, Prof. Dr. rer. nat.**
**Waldstrasse 96**
**D-5100 Aachen(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

(54) **Halbleiteranordnung.**

(57) Die Erfindung betrifft eine Halbleiteranordnung aus einem Halbleiterkörper und einer darauf angeordneten leitenden Halbleiterschicht, an der im Abstand voneinander wenigstens zwei ohmsche Anschlußelektroden angeordnet sind. Die Erfindung besteht darin, daß die leitende Schicht derart dünn gewählt ist, daß eine zwischen den ohmschen Anschlußelektroden auf der Halbleiterschicht angeordnete Sperrschicht in der Halbleiterschicht eine als Majoritätsladungsträger-Barriere wirksame Potentialverteilung erzeugt.

FIG.1

EP 0 268 136 A2

## Halbleiteranordnung

Die Erfindung betrifft eine Halbleiteranordnung aus einem Halbleiterkörper (1) und einer darauf angeordneten leitenden Halbleiterschicht (2), an der im Abstand voneinander wenigstens zwei ohmsche Anschlußelektroden (5,6) angeordnet sind.

In neuartigen Majoritätsträger-Bauelementen werden energetische Barrieren für Majoritätsträger dadurch erzeugt, daß in einem einkristallinem Halbleitermaterial eine extrem dünne Schicht kontradotiert eingebettet wird. So wird beispielsweise in ein n-leitfähiges Material mit einer Dotierung von $10^{14}$ Atomen/cm$^3$ eine nur ca. 10 nm dicke Trennschicht extrem hoher p-Dotierung oberhalb $10^{19}$ Atomen/cm$^3$ eingebaut. Wegen der geringen Dicke der kontra-dotierten Schicht verbleiben dort nur Akzeptor-Rümpfe, während die beweglichen Löcher vollständig ausgeräumt sind. Eine derartige PDB-Diode wird beispielsweise in der Zeitschrift "Materials Letters, Vol. 1, No. 1, June 82, S. 22-25" beschrieben. Diese bekannte Diode hat im wesentlichen das Verhalten einer Schottky-Diode, mit dem Vorteil, daß sie relativ rauscharm ist, da die Barriere im Halbleitervolumen und nicht an der Halbleiteroberfläche angeordnet ist.

Ferner ist aus der Zeitschrift "IEE Proc., Vol. 128, Pt.1, No.4, August 81, S.134-140" eine vertikale Transistor-Konfiguration bekannt, bei der heiße Ladungsträger über eine Emissionsbarriere gesteuert in eine dünne Basiszone einfließen, wonach sie über eine daran anschließende zweite Barriere abgesaugt werden. Die Barriere-Schichten werden auch bei diesem Transitor durch extrem schmale, gegenüber dem Umgebungsmaterial kontradotierte Bereiche gebildet, die durch Diffusion oder Ionenimplantation erzeugt werden und die so schmal sind, daß in ihnen nur die Akzeptor-Rümpfe verbleiben. Die beiden Barrierehöhen werden durch Potentialanlegung gegeneinander verändert, so daß bei genügend geringer Ausdehnung der Basisschicht heiße Elektronen die erste Potentialbarriere durchdringen und über die zweite Potentialbarriere abgesaugt werden.

Der Nachteil dieser Konfigurationen ist, daß es sich um eine vertikale Schichtenfolge handelt, was zum Auftreten unerwünschter parasitären Kapazitäten führt. Aufgabe der vorliegenden Erfindung ist es, diesen Nachteil zu beseitigen. Diese Aufgabe wird erfindungsgemäß dadurch gelöst, daß bei einer Halbleiteranordnung der eingangs beschriebenen Art die leitende Schicht derart dünn gewählt ist, daß eine zwischen den ohmschen Anschlußelektroden auf oder in der Halbleiterschicht angeordnete Sperrschicht in der Halbleiterschicht eine als Majoritätsladungsträger-Barriere wirksame Potentialverteilung erzeugt.

Die Sperrschicht wird vorzugsweise durch einen Schottky-Kontakt gebildet, der senkrecht zur Längsausdehnung der leitenden Schicht zwischen den ohmschen Anschlußelektroden verläuft. Es besteht jedoch auch die Möglichkeit, die Sperrschicht durch eine gleich angeordnete kontradotierte Zone zu bilden.

Bei einer bevorzugten Ausführungsform der Erfindung besteht die leitende Schicht aus einem im Verhältnis zum Material des Halbleiterkörpers - schmalbandigem Material, beispielsweise aus GaAs, während der Halbleiterkörper bei diesem Beispiel aus GaAlAs besteht. Die Sperrschicht wird vorzugsweise unsymmetrisch zwischen den ohmschen Anschlußelektroden angeordnet, um eine Dreiecksbarriere, ähnlich der in der Zeitschrift "Materials Letters" beschriebenen Form zu erhalten. Durch die umsymmetrische Anordnung der Sperrschicht zwischen den ohmschen Anschlußelektroden erhält man auch eine ungleiche Kennliniencharakteristik für positive und negative Spannungen, ähnlich der einer Schottky-Diode. Im Gegensatz zu den bekannten vertikalen Anordnungen, liegt der Vorteil der erfindungsgemäßen lateralen Anordnung darin, daß die Elektroden eine geringe gegenseitige Kapazität bilden und das Bauelement mit Hilfe der bekannten planaren Herstellungsmethode erzeugt werden kann.

In einer vorteilhaften Weiterbildung wird mit Hilfe des erfindungsgemäßen Prinzips ein Lateral-Transistor dadurch verwirklicht, daß zwei Sperrschichten parallel zueinander zwischen den beiden ohmschen Anschlußelektroden angeordnet werden und zwischen diesen Sperrschichten ein dritter ohmscher Anschlußkontakt an die dünne Halbleiterschicht angebracht wird. Der letztgenannte ohmsche Anschlußkontakt bildet dann ein Äquivalent zu dem ansonsten bei Bipolartransistoren üblichen Basisanschluß. Denkbar ist auch, daß zur Ausbildung steuerbarer Bauelemente mit nur einer Sperrschicht an die mit der Sperrschicht verbundene Elektrode ein variables Potential anlegbar ist und so die Höhe des Potentialberges direkt beeinflußt werden kann.

Die Erfindung wird nachstehend noch anhand von Ausführungsbeispielen näher erläutert.

Fig. 1 zeigt eine Diodenstruktur nach der Erfindung.

Fig. 2 zeigt die Potentialverteilung in der leitenden Halbleiterschicht.

Fig. 3 und 4 zeigen den Bänderverlauf entlang der Schnittlinien AA' und BB' aus Figur 1.

Figur 5 zeigt die Kombination zweier Diodenstrukturen zu einer "hot-electron-Transistorstruktur".

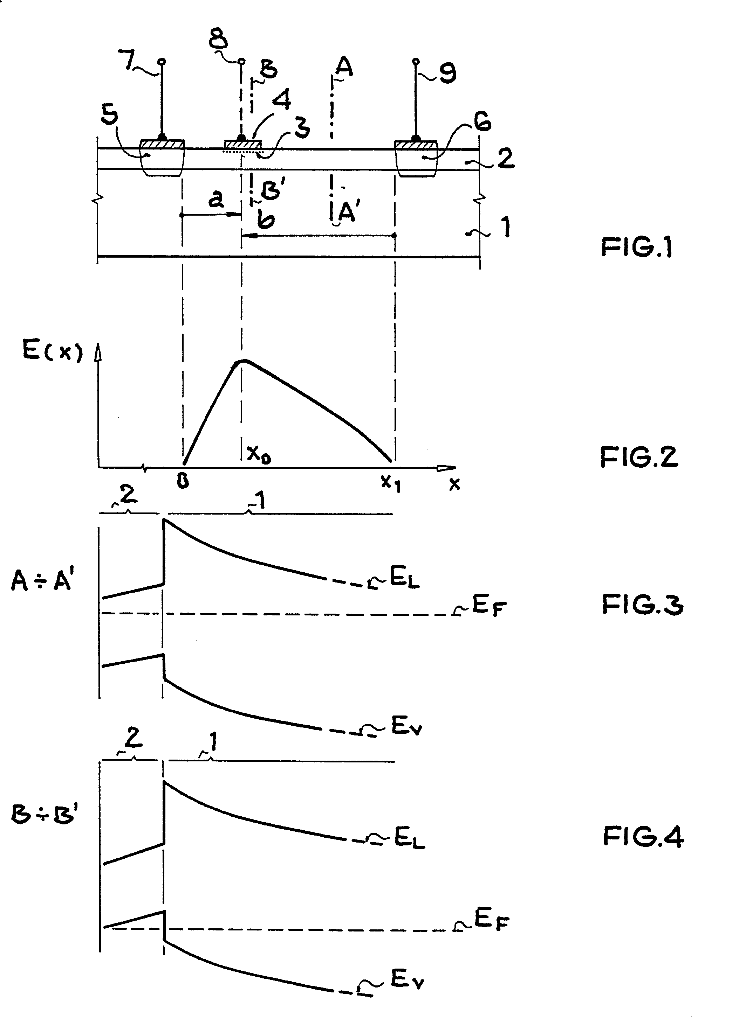

Gemäß Fig. 1 wird zur Herstellung einer Diodenstruktur mit einem Majoritätsladungsträgerstrom von einem Halbleiterkörper (1) ausgegangen, auf den eine extrem dünne leitende Schicht (2) aufgebracht wird. Die dünne leitende Schicht (2) besteht aus einem gegenüber dem Halbleitergrundkörper (1) schmalbandigem Material, beispielsweise aus GaAs, wenn der Halbleiterkörper (1) aus GaAlAs besteht. Die Halbleiterschicht (2) ist beispielsweise n-dotiert und hat eine Dicke von nur ca. 50 nm. An diese sehr dünne leitende Schicht (2) sind im Abstand voneinander zwei ohmsche Anschlußelektroden (5,6) angebracht, zwischen denen im Betriebsfall der Majoritätsladungsträgerstrom fließt. Dieser Majoritätsladungsträgerstrom hat einen Potentialberg zu überwinden, dessen Verlauf durch die Fig. 2 dargestellt ist. Der Potentialberg wird durch die Sperr-Schicht (3) erzeugt, die unsymmetrisch zwischen den ohmschen Anschlußelektroden (5,6) vorzugsweise streifenförmig augebildet ist. Der Sperrschichtstreifen verläuft hierbei senkrecht zur Stromflußrichtung zwischen den Anschlußelektroden (5,6). Die Sperrschicht wird vorzugsweise durch einen Schottky Kontakt erzeugt; sie kann jedoch auch durch eine einimplantierte kontradotierte Oberflächenzone gebildet werden. Die Sperrschicht hat beispielsweise eine Breite von nur 10-20 nm und wird vorzugsweise durch Elektronenstrahllithographie hergestellt. Nach Fig. 1 entsteht die Sperrschicht (3) durch das Aufbringen eines Metalles (4), das an der Verbindungstelle zur leitenden Schicht (2) einen gleichrichtenden Schottky-Kontakt bildet.

Der Abstand a zwischen der Sperrschicht (3) und der einen ohmschen Anschlußelektrode (5) und der Abstand b der Sperrschicht gegenüber der anderen ohmschen Anschlußelektrode 6 ist so gewählt, daß entlang der Strecke 0 bis $x_1$ (Fig. 2) ein unsymmetrischer Potentialberg verläuft. Die Lage der aufgebrachten sperrschichtbildenden Elektrode (4) am Ort $x_0$ (Fig. 2) bestimmt daher den Verlauf des Potentialberges. Wäre $x_0$ in der Mitte zwischen 0 und $x_1$ gelegen, erhielte man einen symmetrischen Potentialberg und auch die Kennlinie zwischen den Elektroden (5,6) hätte einen symmetrischen Verlauf. Ist andererseits wie dargestellt $x_0$ unsymmetrisch zwischen 0 und $x_1$ angeordnet, tritt eine ungleiche Charakteristik positiver und negativer Spannungen in ähnlicher Art auf, wie sie bei einer Dreiecksbarriere entsteht, die in der eingangs genannten Zeitschrift "Materials Letters" erwähnt wird. Die Majoritätsladungsträger in der leitenden Schicht (2) müssen mit Hilfe thermischer Energie diesen Potentialberg überwinden, um von einer Anschlußelektrode zur anderen zu gelangen. Der Abstand a beträgt bei einer Ausführungsform beispielsweise 50 nm, während der Abstand b 200 nm groß ist.

Die zugehörigen Banddiagramme entlang der Schnittlinien AA' bzw. BB' gemäß Fig. 1 sind in den Fig. 3 und 4 dargestellt. Gemäß diesen Figuren liegt auf der breitbandigen Substratseite schwach dotiertes Material, während an der Oberfläche eine dünne Schicht (2) schmalbandigem Halbleitermaterials angeordnet ist. Die Potentialbarriere zwischen den Bereichen 1 und 2 bewirkt, daß die Ladungsträger -bei einer n-leitenden Schicht (2) die Elektronen-in der Oberflächenschicht (2) verbleiben und in dieser Schicht frei beweglich sind. An der Stelle, wo aufgrund der Sperrschicht (3) eine Potentialbarriere auftritt (Schnitt BB' gemäß Fig. 4) wird das Potential der Banddiagramme insgesamt stark angehoben. Dies kann soweit gehen, daß eine Invertierung des Schichtbereiches (2) unterhalb und in engster Nachbarschaft der Metall-Schottky-Elektrode (4) (Fig. 1) auftritt, was bis zum Zustand der Entartung gehen kann.

Dieser Zustand der Entartung ist bei dem Banddiagramm gemäß Fig. (4) angenommen. Damit besteht der Raumbereich unterhalb der Schottky-Elektrode (4) scheinbar aus hoch p-dotiertem Material und die hier auftretende laterale Barriere entspricht einer Barriere, die bei Camel-Dioden durch extreme Kontradotierung hervorgerufen wird.

Gemäß Fig. 1 werden die Anschlußelektroden (5,6) mit Potentialanschlüssen (7,9) versehen. Auch an den Schottky-Kontakt (4) kann eine Anschlußelektrode (8) zur Anlegung eines externen Potentials vorgesehen werden. Mit diesem variablen externen Potential an der Anschlußelektrode (8) könnte die Höhe des Potentialberges gemäß Fig. 2 und damit das elektrische Verhalten der Halbleiteranordnung beeinflußt werden.

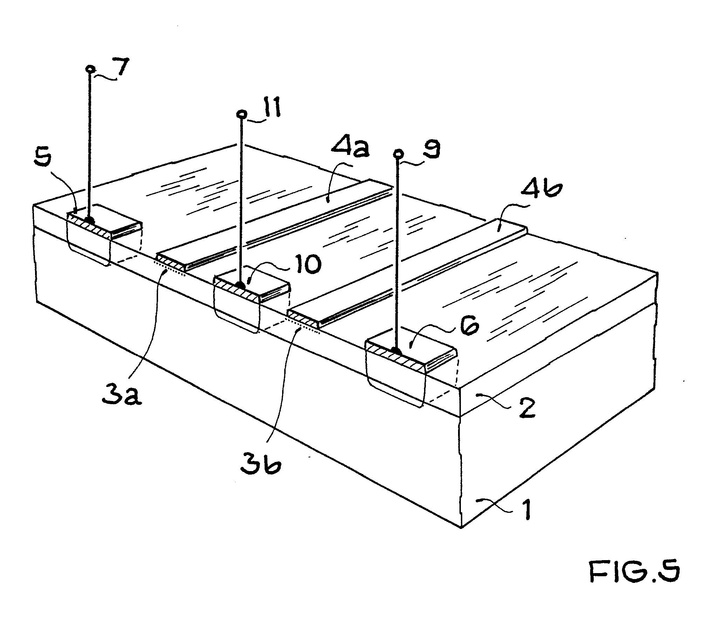

Durch Kombination von zwei Dioden bzw. Dreieckbarrieren gemäß Fig. 1 läßt sich bei passender Geometrie ein "hot-electron-Transistor" erzeugen. Ein entsprechendes Äquivalent ist in der Fig. 5 dargestellt. Nach der Fig. 5 werden zwei unsymmetrische Anordnungen gemäß der Fig. 1 spiegelbildlich angeordnet. Diese Struktur weist dann zwei Sperrschichten 3a, 3b auf, die durch Schottky-Kontakte 4a, 4b an der leitenden Schicht (2) erzeugt werden. Zwischen diesen beiden Schottky-Kontakten befindet sich im gleichen Abstand eine ohmsche Anschlußelektrode (10), die als Äquivalent zum Basisanschluß eines Lateraltransistors angesehen werden kann und mit dem Anschluß (11) versehen wird. Die beiden Potentialberge, die durch die Sperrschichten 3a und 3b erzeugt werden, sind zu dieser Anschlußelektrode (10) symmetrisch angeordnet. Ihr Abstand zu den äußeren Anschlußelektroden (7) bzw. (9) ist größer als der zur mittleren Anschlußelektrode (10), so daß Dreiecksbarrieren entstehen. Der Abstand zwischen dem Potentialmaximum der beiden Potentialwerte ist vorzugsweise kleiner als 0,2 μm. Dieser geringe Abstand zwischen den beiden Potentialbergen muß gewählt werden, um sicherzustellen, daß Elektronen, die die Barriere unterhalb der Schottky-Elektrode 4a überschreiten, in der Lage sind, als heiße Elektronen das Raumgebiet im Bereich der Anschlußelektrode (10) ohne wesentliche Störung zu durchlaufen, um dann bei passender Vorspannung der Elektrode (9) den unterhalb der Schottky-Elektrode 4b gelegenen Potentialberg überwinden zu können.

Auch bei dem Ausführungsbeispiel nach Fig. 5 besteht die prinzipielle Möglichkeit, die Schottky-Elektroden 4a und 4b zusätzlich zu beschalten, um damit eine Modulation der Potentialberge unterhalb dieser Schottky-Kontakte zu bewirken.

## Ansprüche

1) Halbleiteranordnung aus einem Halbleiterkörper (1) und einer darauf angeordneten leitenden Halbleiterschicht (2), an der im Abstand voneinander wenigstens zwei ohmsche Anschlußelektroden (5,6) angeordnet sind, dadurch gekennzeichnet, daß die leitende Schicht (2) derart dünn gewählt ist, daß eine zwischen den ohmschen Anschlußelektroden (5,6) auf oder in der Halbleiterschicht angeordnete Sperrschicht (3) in der Halbleiterschicht (2) eine als Majoritätsladungsträger-Barriere wirksame Potentialverteilung (E (x) Fig. 2) erzeugt.

2) Halbleiteranordnung nach Anspruch 1, dadurch gekennzeichnet, daß die Sperrschicht (3) durch einen Schottkykontakt (4) gebildet ist, der senkrecht zur Längsausdehnung der leitenden Schicht zwischen den ohmschen Anschlußelektroden (5,6) verläuft.

3) Halbleiteranordnung nach Anspruch 1, dadurch gekennzeichnet, daß die Sperrschicht (3) durch eine zur leitenden Schicht (2) kontradotierte Zone gebildet ist, die senkrecht zur Längsausdehnung der leitenden Schicht zwischen den ohmschen Anschluß elektroden (5,6) verläuft.

4) Halbleiteranordnung nach einem der vorangehenden Ansprüche, dadurch gekennzeichnet, daß die Sperrschicht (3) unsymmetrisch zwischen den ohmschen Anschlußelektroden (5,6) angeordnet ist.

5) Halbleiteranordnung nach einem der vorangehenden Ansprüche, dadurch gekennzeichnet, daß die leitende Schicht (2) aus im Verhältnis zum Material des Halbleiterkörpers (1) schmalbandigem Material besteht.

6) Halbleiteranordnung nach Anspruch 5, dadurch gekennzeichnet, daß die leitende Schicht (2) aus GaAs und der Halbleiterkörper (1) aus GaAlAs besteht.

7) Halbleiteranordnung nach einem der vorangehenden Ansprüche, dadurch gekennzeichnet, daß die leitende Schicht (2) ca. 50 nm dick ist.

8) Halbleiteranordnung nach einem der vorangehenden Ansprüche, dadurch gekennzeichnet, daß in oder auf der leitenden Schicht mehrere parallel zueinander angeordneten Sperrschichten (3a, 3b) ausgebildet sind.

9) Halbleiteranordnung nach Anspruch 8, dadurch gekennzeichnet, daß zwischen den Sperrschichten (3a, 3b) jeweils eine ohmsche Anschlußelektrode (10) an der leitenden Schicht (2) angeordnet ist.

10) Halbleiteranordnung nach Anspruch 8 oder 9, dadurch gekennzeichnet, daß eine Anordnung mit zwei Sperrschichten (3a, 3b) als Majoritätsladungsträger-Lateraltransistor vorgesehen ist, wobei die symmetrisch zwischen den Sperrschichten (3a, 3b) angeordnete ohmsche Anschlußelektrode (10) an der leitenden Schicht (2) äquivalent zu einem Basisanschluß ist.

11) Halbleiteranordnung nach einem der vorangehenden Ansprüche, dadurch gekennzeichnet, daß zur Ausbildung steuerbarer Bauelemente mit nur einer Sperrschicht an die mit der Sperrschicht verbundenen Elektrode ein variables Potential anlegbar ist.

12) Halbleiteranordnung nach einem der vorangehenden Ansprüche, dadurch gekennzeichnet, daß die Sperrschicht (3) eine Breite von ca 10-20 nm aufweist.

13) Halbleiteranordnung nach Anspruch 9 oder 10, dadurch gekennzeichnet, daß der Abstand der Sperrschichten (3a, 3b) von der Mittenelektrode (10) gleich groß ist, sich jedoch vom Abstand gegenüber den äußeren Anschlußelektroden (5,6) unterscheidet.

14) Halbleiteranordnung nach Anspruch 9, 10 oder 13, dadurch gekennzeichnet, daß der Abstand zwischen den Maxima der Potentialberge im Bereich der Sperrschichten (3a, 3b) kleiner als 0,2 μm ist.

FIG.1

FIG.2

FIG.3

FIG.4

FIG.5